Europäisches Patentamt

European Patent Office

Office européen des brevets

(11) Publication number: **0 267 768**
A1

## (12) EUROPEAN PATENT APPLICATION

(21) Application number: 87309887.5

(22) Date of filing: 09.11.87

(51) Int. Cl.⁴: **H 01 L 29/06**
H 01 L 29/78, H 01 L 29/08

(30) Priority: 10.11.86 US 929028

(43) Date of publication of application:
18.05.88 Bulletin 88/20

(84) Designated Contracting States:
BE DE FR GB IT NL

(71) Applicant: **SILICONIX incorporated**
**2201 Laurelwood Road**
**Santa Clara California 95054 (US)**

(72) Inventor: **Blanchard, Richard A.**
**10724 Mora Drive**
**Los Altos California 94022 (US)**

(74) Representative: **Jones, Ian et al**
**POLLAK MERCER & TENCH High Holborn House 52-54**
**High Holborn**
**London WC1V 6RY (GB)**

(54) **High voltage drifted-drain MOS transistor.**

(57) A drifted drain MOS transistor incorporates a P-type channel (15) between P type regions (14,16) located between the source and the drain regions. The P- channel (15) provides a conduction path from the region below the gate (22) to the P drain region. When a large reverse bias is present at the P-N junction, the P-channel region (15) depletes producing a P-channel MOS transistor with high breakdown voltage and high lateral PNP current gain when operated with the drain as its emitter. When the PMOS transistor is fabricated in an N- well (28) surrounded by P- type material (30), the vertical PNP current gain of the bipolar transistor formed with the drain on the collector is low when compared to the lateral PNP current gain.

FIG. 3

## Description

## HIGH VOLTAGE DRIFTED-DRAIN MOS TRANSISTOR

This invention relates to a metal-oxide-semiconductor (MOS) transistor and in particular to a drifted-drain MOS transistor suitable for high voltage operation.

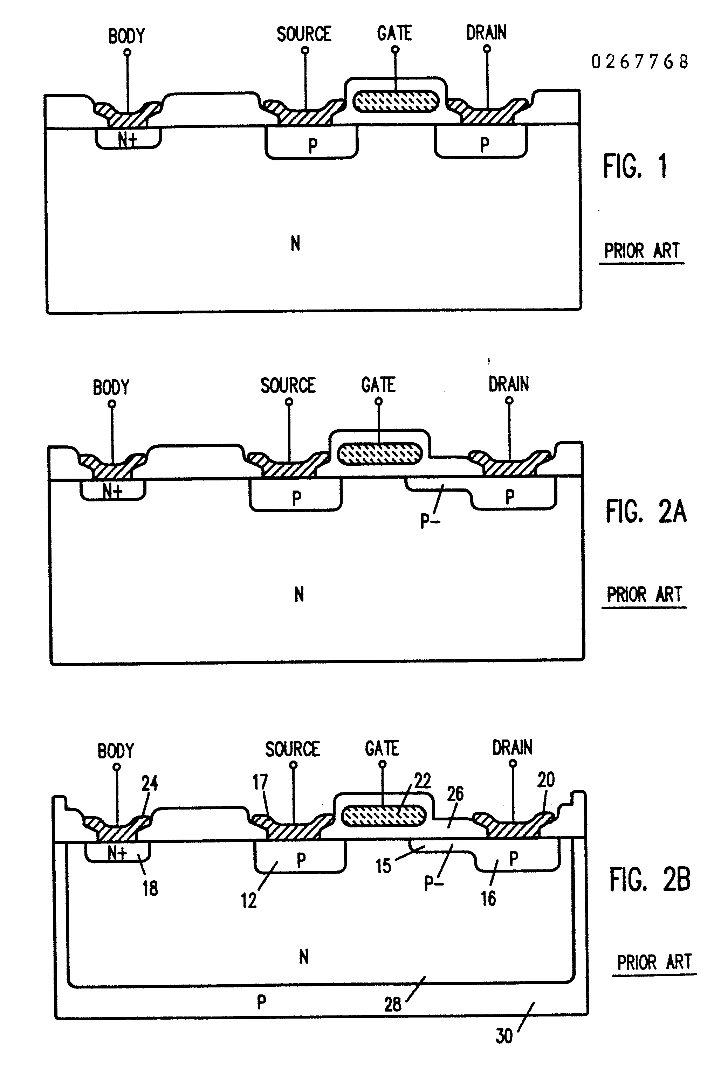

MOS transistors are devices consisting of diffused source and drain regions on either side of a P or N channel region, and a gate electrode insulated from the channel by silicon oxide. In some instances, the gate dielectric may be a sandwich such as $SiO_2/Si_3N_4$. When the proper control voltage is applied to the gate, the "channel" is accumulated, allowing carriers to flow between the source and the drain. A conventional P channel MOS transistor is illustrated in Figure 1, by way of example. The transistor is formed with an N type substrate, having two P regions adjacent to the source and drain with a gate electrode interposed between the source and drain. The body region is contacted with an N+ region.

Integrated circuits which operate at relatively high voltages generally require MOS transistors that are capable of withstanding the full operating voltage of the circuit. Conventional MOS structures of the P channel or N channel type generally are not capable of sustaining high voltage operation and are subject to breakdown when high voltages are applied. The breakdown voltage is limited by field plate induced breakdown or by planar junction breakdown. The field plate induced breakdown occurs when the maximum breakdown voltage is exceeded at a junction in the vicinity of a biased gate of the MOS transistor. This maximum breakdown voltage is determined by the distance between the gate electrode and the drain, and the dopant profile of the drain junction. The planar junction breakdown is determined by the radius of curvature of the drain junction and the dopant concentration of the substrate. Breakdown occurs when the electric field in the vicinity of the junction exceeds the critical field of silicon.

One major objective of the semiconductor technology is to develop a transistor having a significant increase in the level of breakdown voltage. One type of transistor that can be adapted for this purpose is the drifted-drain MOS transistor, delineated in Fig. 2a. The drifted-drain MOS P-channel transistor is characterized by a lightly doped P-region that extends from the contacted drain region to the gate, thereby providing a conduction path from the region below the gate, which is inverted when the transistor is biased ON, to the P+ drain region. The P- region does not decrease the breakdown voltage of the device because the dopant concentrations is kept sufficiently low. When a large reverse bias appears at the junction, this P- region depletes, thus increasing the breakdown voltage that is normally set by the radius of curvature of the P+ region. One characteristic of the drifted-drain MOS transistor is the bipolar current gain of the lateral PNP transistor which is formed when the drain region is biased as the emitter, the body region is biased as the base, and the source region is biased as the collector. With this type of configuration, the bipolar performance is limited by the ability of the lightly doped P- region to supply carriers, which is known as the emitter injection efficiency. This characteristic is largely determined by the relative concentrations of the "emitter" and the "base" regions. If the high voltage drifted-drain PMOS transistor of Fig. 2a is surrounded by a P- type region as shown in Fig. 2b, the current gain of the vertical PNP formed by using drain region 16 as the emitter, body region 28 as the base, and P-type region 30 as the collector may be higher than the lateral PNP formed by the drain (emitter), body (base), and source (collector) regions as described above. In certain circuit configurations, this vertical PNP action can be detrimental to its functioning.

In accordance with this invention, a drifted-drain MOS transistor comprises a source region, a drain region, and a gate electrode. A lightly doped P-region connects a P+ region adjacent to the gate with a P+ region that contacts the drain. The carriers in the connecting P- region are depleted when a large reverse bias is applied at the PN junction, thereby decoupling the P+ regions. As a result, the breakdown voltage is increased, and the magnitude of the breakdown is dependent upon the relative concentrations of the P and N type regions and the distance between the two P+ regions of the drain.

This invention thus provides an MOS drifted-drain transistor having a high breakdown voltage characteristic and a high lateral PNP current gain when a large reverse bias is applied to the drain junction.

The invention is further described below, by way of example, with reference to the accompanying drawing, in which:

Figure 1 is a cross-sectional view of a conventional P channel MOS transistor;

Figures 2a and 2b are cross-sectional views of prior art high voltage drifted-drain P channel MOS transistors, with and without a surrounding P- type region respectively;

Figure 3 is a cross-sectional view of a high voltage drifted-drain P- channel MOS transistor in accordance with this invention; and

Figures 4a and 4b illustrate variations of the embodiment of Figure 3.

Similar numerals refer to similar elements throughout the drawing.

Although the description in this application is directed to a P channel MOS transistor, it should be understood that the invention is equally applicable to N channel MOS devices.

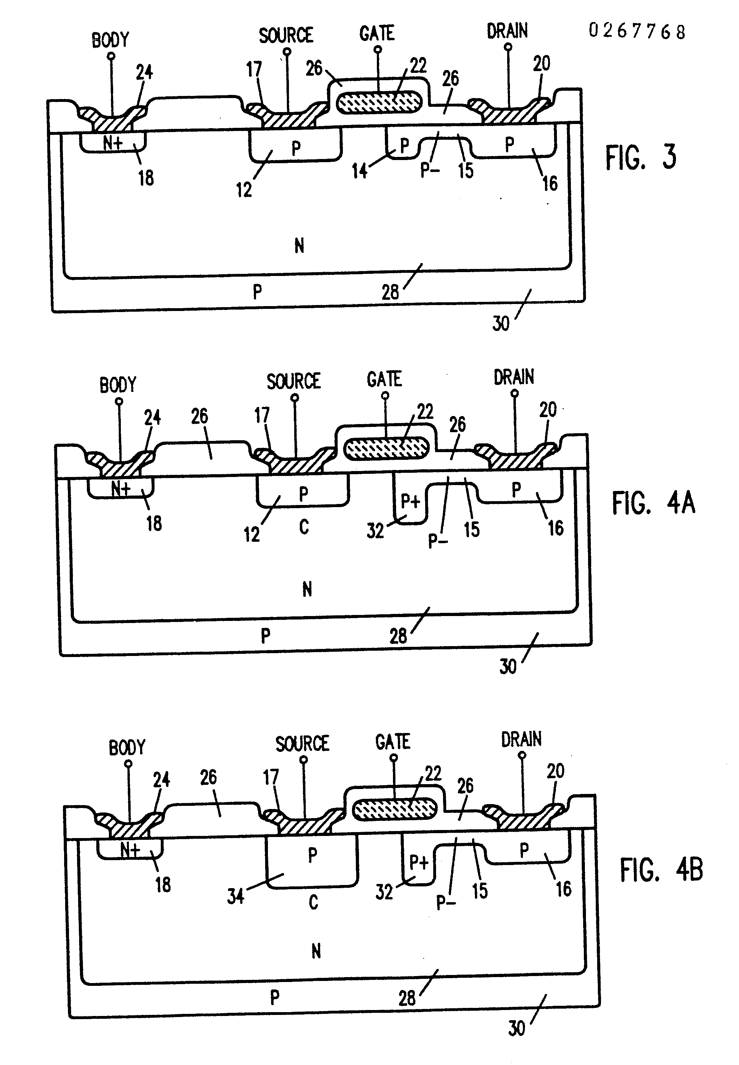

As illustrated in Fig. 3, a high voltage drifted-drain P channel MOS transistor is formed in an N type silicon substrate 10 having spaced P conductivity regions 12, 14, and 16. The P regions are produced by diffusion or ion implantation, by well known masking and photolithographic techniques. A dopant, such as boron is introduced into the major surface of the substrate 10, as is well known in the art to form the P conductivity regions. A heavily diffused N+ region 18 is formed in an area spaced from the P conductivity regions by diffusing a dopant, such as phosphorous or arsenic, into the major surface of the substrate 10.

The transistor structure is formed with a source metallization 17 above the P region 12, a drain metallization 20 disposed above the P region 16, and a gate electrode 22 formed between the source and drain. A body metallization 24 is deposited over the N+ region 18. Dielectric or insulating material 26 is laid down or grown around the gate electrode and between the source, drain and body regions.

In keeping with this invention, a resistor is formed by a lightly doped P- region 15 that connects the P regions 14 and 16. The P- region depletes when a large reverse bias is applied to the PN junction, so that the breakdown voltage that is normally set by the radius of curvature of the P+ region is increased. With a sufficiently large body-to-drain bias, the P- region is totally depleted thereby electrically decoupling the P+ regions 14 and 16. The breakdown voltage is determined by the relative concentrations of the P and N type regions and the distance between the P+ regions 14 and 16 associated with the drain.

In the embodiment of Fig. 3, the PMOS transistor is illustrated having an N well 28 that is encompassed by an extended P conductivity region 30. The vertical PNP structure, which is formed by the P+ drain region that serves as an emitter, the N type body region which serves as the base, and the P type substrated that serves as the collector, tends to divert current from the intended path through the lateral PNP transistor. However, the relative doping concentrations and the lateral dimensions of the regions of the transistor serve to effectively reduce the vertical PNP current gain while increasing the lateral PNP current gain.

Fig. 4a depicts a PMOS structure of the type shown in Fig. 3, wherein a heavily doped emitter 32 is used. Fig. 4b illustrates a similar structure, with a heavily doped collector 34 and emitter 32 of the lateral PNP transistor. The structure is formed with a lightly doped drain contact diffusion on the emitter 16 of the parasitic vertical PNP transistor. The lightly doped P- region that connects the P+ region adjacent to the gate to the P+ drain contact region depletes to increase the breakdown voltage. In this way, the percentage of current that flows through the undesirable vertical PNP transistor is effectively minimized.

type in the substrate below the major surface.
a source metallization (17) on the major surface above the first region,
a drain metallization (20) on the major surface above the third region, and
a gate electrode (22) formed on the major surface above and between the first and second regions,
characterized by a lightly diffused channel (15) formed between and connecting the second and third regions, whereby the MOS transistor sustains relatively high voltages when operating in an integrated circuit.

2. A transistor as claimed in claim 1 characterised in that the substrate (10) is formed of N type material, the first, second and third regions (12, 14 & 16) are formed of P type and the channel (15) is a P-type channel.

3. A transistor as claimed in claim 2 including a body region (28) and characterized by a high lateral PNP current gain when operated with the drain region (16) as an emitter, the body region as the base, and the source region (12) as the collector.

4. A transistor as claimed in claim 2 or 3 including a fourth P- type region (30) that forms a well for the N type substrate (10) and characterized by a low vertical PNP current gain when the source nd body regions (12 & 28) are operated as the collector and base respectively, and the fourth P- type region (30) that surrounds the substrate is operated as the collector.

5. A transistor as claimed in claim 2, 3 or 4 characterized by an N+ region (18) spaced from the first P type region (12) and formed below the major surface, and a body metallization (24) formed over the N+ region.

6. A transistor as claimed in any one of claims 2-5 characterized in that the second P type region (14) is formed as a heavily doped emitter (32).

7. A transistor as claimed in any one of claims 2-6 wherein the P type region that is disposed below said source is formed as a heavily doped collector (34).

8. A transistor as claimed in any preceding claim characterized by insulating material (26) encompassing the gate electrode (22).

## Claims

A high-voltage drifted-drain metal-oxide-semiconductor (MOS) transistor comprising
a substrate (10) formed of semiconductor material of first conductivity type having a major surface,
first, second, and third spaced regions (12,14 & 16) formed of material of opposite conductivity

BODY    SOURCE    GATE    DRAIN

0267768

FIG. 1

PRIOR ART

BODY    SOURCE    GATE    DRAIN

FIG. 2A

PRIOR ART

BODY    SOURCE    GATE    DRAIN

FIG. 2B

PRIOR ART

FIG. 3

FIG. 4A

FIG. 4B

European Patent
Office

EUROPEAN SEARCH REPORT

Application Number

EP 87 30 9887

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | PROCEEDINGS OF THE 6TH CONFERENCE ON SOLID STATE DEVICES, Tokyo 1974, Supplement to the Journal of the Japan Society of Applied Physics, vol. 44, 1975, pages 249-255; I. YOSHIDA et al.: "Device Design of an Ion Implanted High Voltage MOSFET" * figure 9; abstract; page 253, paragraph 4.2 * | 1,2,6,7 | H 01 L 29/06<br>H 01 L 29/78<br>H 01 L 29/08 |
| Y | idem | 3,4 | |
| Y | IEEE TRANSACTIONS ON ELECTRON DEVICES, vol. ED-32, no. 11. November 1985, pages 2277-2281, New York, US; J.D. MORSE: "Optimized design of a merged bipolar MOSFET device" * figure 1; figure 6; pages 2278-2280, paragraphs III, IV * | 3,4 | |
| A | IEEE SPECTRUM, vol. 22, no. 7, July 1985, pages 42-48, New York, US; "Power devices are in the chips" * page 45, figure C * | 4,8 | **TECHNICAL FIELDS SEARCHED (Int. Cl.4)**<br><br>H 01 L |

The present search report has been drawn up for all claims

| Place of search | Date of completion of the search | Examiner |
|---|---|---|
| BERLIN | 15-01-1988 | JUHL A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)